# EUROPÄISCHE PATENTSCHRIFT

(11) **EP 2 299 472 B1**
(45) Veröffentlichungstag und Bekanntmachung des Hinweises auf die Patenterteilung: **08.07.2020**
(21) Anmeldenummer: 09012023.9
(22) Anmeldetag: 22.09.2009
(51) Int. Cl.: H01L 21/68, H01L 21/67

(54) **Vorrichtung zum Ausrichten zweier Substrate**
Device for aligning two substrates
Dispositif d'alignement de deux substrats

(43) Veröffentlichungstag der Anmeldung: 23.03.2011
(73) Patentinhaber: EV Group E. Thallner GmbH, 4782 St. Florian am Inn (AT)
(72) Erfinder: Figura, Daniel, 4791 Rainbach im Innkreis (AT)
(74) Vertreter: Schweiger, Johannes

(56) Entgegenhaltungen:
- EP-A1- 1 278 245
- EP-A2- 1 675 165
- WO-A1-2009/022457
- JP-A- 2008 096 605

## Beschreibung

Die Erfindung betrifft eine Vorrichtung zum Ausrichten einer ersten Kontaktfläche eines ersten Substrats mit einer zweiten Kontaktfläche eines zweiten Substrats gemäß Anspruch 1 und ein entsprechendes Verfahren gemäß Anspruch 10.

Für die gegenüberliegende Anordnung und Ausrichtung von den Kontaktflächen zweier Substrate, beispielsweise Wafer, insbesondere von nicht transparenten Wafern, sind verschiedene Vorgehensweisen bekannt.

Eine bekannte Vorgehensweise ist die Verwendung zweier Mikroskoppaare, die jeweils auf einen bestimmten Betrachtungspunkt kalibriert werden. Zur Ausrichtung wird zunächst der untere Wafer unter die oberen Mikroskope gefahren und die Mikroskope werden zu dem unteren Wafer ausgerichtet, die Position fixiert und die zwei Ausrichtungsschlüssel der Wafer gespeichert. Anschließend wird der obere Wafer zu den gespeicherten Ausrichtungsschlüsseln unter Verwendung der unteren Mikroskope ausgerichtet. Anschließend wird der untere Wafer in seine ursprüngliche Position gefahren und die Wafer werden kontaktiert. Mit dem vorbeschriebenen Verfahren kann zwar eine hohe Genauigkeit bei der Positionierung erreicht werden. Das System arbeitet aber nur aufgrund der erfassten Relativpositionen der beiden Ausrichtungsschlüssel auf beiden Wafern zueinander, sodass die Kalibrierung der Mikroskope zueinander und die Bewegung der Wafer bei der Ausrichtung zu Fehlern beim Ausrichten führen können. Weiterhin ist die Anzahl der Messpunkte auf dem Wafer begrenzt. Das vorbeschriebene Verfahren ist in der US 6,214,692 beschrieben.

Ein anderer Ansatz besteht darin, zwei Mikroskoppaare zwischen den zu kontaktieren Wafern anzuordnen, um die zwei Ausrichtungsschlüssel gegenüberliegend auszurichten, die Mikroskope anschließend herauszufahren und die Wafer anschließend genau auf einander zu zu bewegen. Auch hierbei können entsprechende Fehler durch die Relativbewegung der Wafer aufeinander zu und die Relativerfassung der Ausrichtungsschlüssel auftreten.

Die Ausrichtungsgenauigkeit bekannter Ausrichtungstechnologien liegt im Bereich von 0,5µm, wobei die Verteilung von auf den Wafern befindlichen, zueinander auszurichtenden Strukturen, beispielsweise Chips und etwaige Abweichungen der Chips von den vorgegebenen oder nominellen Positionen auf dem Wafer, bisher nicht berücksichtigt wird. Durch das zunehmende Interesse an der 3D-Integration sinken das Abstandmaß und die Größe von Bohrlöchern, sodass ein großer Bedarf für eine genauere Ausrichtung vorhanden ist. Die Abweichung von der nominellen Position der Ausrichtungsstrukturen wurde bisher vernachlässigt, da die bisher mögliche Justiergenauigkeit weit mehr als das 10-fache dieser Abweichungen betrug. Die Abweichungen betragen regelmäßig weniger als 100 nm.

Ein großes Problem der bestehenden Lösungen ist die mechanische Genauigkeit der Bewegungen der Komponenten zueinander.

Ein weiteres Problem besteht in der optischen Erkennungsgenauigkeit aufgrund des erforderlichen Arbeitsabstands der Optiken von den Wafern. Bei typischen Ausrichtungsvorrichtungen (beispielsweise US 6,214,692) muss der Arbeitsabstand groß genug sein, um die Haltevorrichtungen für die Substrate zwischen den Optiken verfahren zu können. Die Notwendigkeit für diesen Abstand begrenzt die maximal verwendbare Vergrößerung dieser Mikroskope und damit die maximal erreichbare Erfassungsgenauigkeit für die Ausrichtungsschlüssel und in weiterer Folge die Ausrichtungsgenauigkeit.

Bei Anordnung der Optik zwischen den Wafern ist die orthogonale Ausrichtung der Optiken zu den Kontaktflächen der Wafer ein weiterer Aspekt, der zu Fehlern im Mikro- beziehungsweise Nanometer-Bereich führt.

Die WO 2009/022457 A1 beschreibt als nächstliegenden Stand der Technik eine Bondvorrichtung mit einem ersten, fixierten Tisch zur Aufnahme eines Substrats und einem zweiten, in einer X-Y-Ebene beweglichen Tisch zur Aufnahme eines zweiten Substrats. Die EP 1 278 245 A1 beschreibt ein Verfahren und eine Vorrichtung zum Bonden von Wafern mit zwei in X- und Y-Richtung beweglichen Tischen zur Aufnahme der zu bondenden Wafer. Die EP 1 675 165 A2 offenbart ein Verfahren zur dreidimensionalen Ausrichtung von Wafern.

Es ist daher die Aufgabe der vorliegenden Erfindung, eine gattungsgemäße Vorrichtung beziehungsweise ein gattungsgemäßes Verfahren derart zu verbessern, dass eine höhere, insbesondere die gesamte Fläche des Wafers betreffende Ausrichtungsgenauigkeit erreicht wird und Ausschussfaktoren bezüglich der Ausrichtungsgenauigkeit minimiert werden. Daneben liegt der vorliegenden Erfindung die Aufgabe zugrunde, den Durchsatz bei der Ausrichtung von Wafern zu erhöhen.

Diese Aufgabe wird mit den Merkmalen der Ansprüche 1 und 10 gelöst. Vorteilhafte Weiterbildungen der Erfindung sind in den Unteransprüchen angegeben.

Der Erfindung liegt der Gedanke zugrunde, eine Vorrichtung und ein Verfahren anzugeben, bei welchen die X-Y-Positionen von Ausrichtungsschlüsseln zweier auszurichtender Substrate in mindestens einem, von einer Bewegung der Substrate unabhängigen X-Y-Koordinatensystem erfassbar beziehungsweise messbar sind, sodass die Ausrichtungsschlüssel eines ersten Substrats durch Korrelation der zugehörigen Ausrichtungsschlüssel eines zweiten Substrats in entsprechende Ausrichtungspositionen ausgerichtet werden können. Mit einer solchen Vorrichtung beziehungsweise einem solchen Verfahren sind Ausrichtungsgenauigkeiten von < 0,25 µm, insbesondere < 0,15 µm, vorzugsweise < 0,1 µm realisierbar.

Mit anderen Worten: Die Vorrichtung stellt Mittel zur Erfassung der Bewegung der Substrate, insbesondere ausschließlich in einer X- und Y-Richtung, zur Verfügung, die auf mindestens einen festen, insbesondere ortsfesten, Bezugspunkt bezogen sind und damit zumindest in einer X- und Y-Richtung eine exakte Ausrichtung der korrespondierenden Ausrichtungsschlüssel ermöglichen.

Dies wird insbesondere dadurch ermöglicht, dass neben Erfassungsmitteln für die Erfassung der X-Y-Positionen der Ausrichtungsschlüssel gesonderte Positionserfassungsmittel zur Erfassung der Position der Substrate, insbesondere der Position von die Substrate fixiert aufnehmenden Plattformen, vorgesehen sind. Als Positionserfassungsmittel kommen Laserinterferometer und/oder Linearmotoren zur Bewegung der Plattformen in X- und Y-Richtung in Frage.

Die X-Y-Positionen der Ausrichtungsschlüssel auf dem ersten Substrat werden durch erste Erfassungsmittel in das zugeordnete erste X-Y-Koordinatensystem übertragen und, insbesondere gleichzeitig, werden die X-Y-Positionen der Ausrichtungsschlüssel auf dem zweiten Substrat durch zweite Erfassungsmittel in das zugeordnete, insbesondere mit dem ersten X-Y-Koordinatensystem identische, zweite X-Y-Koordinatensystem übertragen. In dieser Erfassungsposition wird durch Positionserfassungsmittel zur, insbesondere mittelbaren, Erfassung der Position des ersten Substrats die X-Y-Position des ersten Substrats und, insbesondere gleichzeitig, wird durch Positionserfassungsmittel zur, insbesondere mittelbaren, Erfassung der Position des zweiten Substrats die X-Y-Position des zweiten Substrats erfasst.

Soweit eine Bewegung eines der Substrate erforderlich ist, beispielsweise zur Ausrichtung oder Positionierung, wird diese durch an sich bekannte, mindestens um einen Faktor 5, insbesondere Faktor 10, vorzugsweise Faktor 50, genauere Antriebsmittel als die erreichbare Ausrichtungsgenauigkeit bewirkt, beispielsweise durch Linearmotoren. Die Antriebsmittel können gleichzeitig als Positionserfassungsmittel dienen. Damit sind die X-Y-Positionen der Substrate bekannt. Noch bevorzugter sind die Positionen der die Substrate jeweils fixiert aufnehmenden Aufnahmeeinrichtungen und/oder Plattformen durch zumindest um einen Faktor 10, insbesondere Faktor 50, vorzugsweise Faktor 100 genauere Positionserfassungsmittel, beispielsweise Laserinterferometer, erfassbar, um Fehler bei der Positionierung weiter zu minimieren.

Die Position der jeweiligen Erfassungsmittel in Relation zu oder auf der jeweiligen Aufnahmeeinrichtung oder Plattform ist fix oder zumindest genau messbar, insbesondere mit einer mindestens um einen Faktor 10, insbesondere Faktor 20, vorzugsweise Faktor 50 höheren Genauigkeit als die Ausrichtungsgenauigkeit.

Besonders vorteilhaft ist dabei, dass mehr als zwei Ausrichtungsschlüssel auf jedem Substrat messbar sind, da der Fachmann auf Grund des bisher erforderlichen Arbeitsabstands bei der Erfassung der Justiermarken die Verwendung von mehr als zwei Ausrichtungsmarken mangels einer Verbesserung des Ausrichtungsergebnisses durch eine solche Maßnahme nicht in Erwägung zog. Die Messung von mindestens drei Ausrichtungsschlüsseln für die Ausrichtung von Wafern ist als eigenständiger Gedanke zu betrachten, insbesondere in Kombination beliebiger Merkmale der vorliegenden Erfindung.

Weiterhin ist es durch die vorbeschriebene Ausgestaltung möglich, als Ausrichtungsschlüssel auf dem Substrat befindliche Strukturen, insbesondere Chips, zu verwenden, sodass auf gesondert aufgebrachte Justiermarken verzichtet werden kann, die bisher zur Ausrichtung erforderlich waren. Die vorliegende Erfindung ermöglicht es aufgrund der hohen Erfassungsgenauigkeit und der Flexibilität der Wahl der Ausrichtungsschlüssel auch, bereits existierende Marken zum Beispiel von der Lithographie, insbesondere Stepper Alignment Marken, die sich an den Ecken der Belichtungsfelder befinden, zu verwenden.

Darüber hinaus sind die erfindungsgemäße Vorrichtung und das erfindungsgemäße Verfahren adaptiv beziehungsweise selbst lernend ausgestaltbar, indem durch Messung des Ausrichtungsergebnisses und Vergleich mit dem berechneten oder nominellen Ergebnis eine Kalibrierung beziehungsweise Optimierung der Ausrichtung der nächsten Substratpaarung vorgenommen werden kann. Auch dieses Merkmal ist als eigenständiger Gedanke zu betrachten, insbesondere in Kombination beliebiger Merkmale der vorliegenden Erfindung.

Als Koordinatenursprung im Sinne der Erfindung kann jeder definierte Punkt des jeweiligen Koordinatensystems gewählt werden. Substrate im Sinne der vorliegenden Erfindung sind sehr dünne und im Verhältnis dazu großflächige Substrate, insbesondere Wafer.

Als Kontaktfläche sind die jeweils zueinander korrespondierenden Flächen der auszurichtenden und zu kontaktierenden Substrate bezeichnet, wobei die Kontaktfläche keine geschlossene Fläche bilden muss, sondern auch von entsprechenden Strukturen, insbesondere Chips oder Topographien, gebildet sein kann.

In einer allgemeinen Ausführungsform der Erfindung weist die Vorrichtung daher folgende Merkmale auf:
- erste X-Y-Positionen von entlang der ersten Kontaktfläche angeordneten ersten Ausrichtungsschlüsseln sind durch erste Erfassungsmittel in einer ersten X-Y-Ebene in einem ersten, von einer Bewegung des ersten Substrats unabhängigen X-Y-Koordinatensystem erfassbar,
- zweite X-Y-Positionen von entlang der zweiten Kontaktfläche angeordneten, zu den ersten Ausrichtungsschlüsseln korrespondierenden zweiten Ausrichtungsschlüsseln sind durch zweite Erfassungsmittel in einer zweiten, zur ersten X-Y-Ebene parallelen X-Y-Ebene in einem zweiten, von einer Bewegung des zweiten Substrats unabhängigen X-Y-Koordinatensystem erfassbar,
- die erste Kontaktfläche ist auf Grundlage der ersten X-Y-Positionen in einer ersten Ausrichtungsposition und die zweite Kontaktfläche ist auf Grundlage der zweiten X-Y-Positionen in einer zweiten Ausrichtungsposition ausrichtbar.

Ein erfindungsgemäßes Verfahren weist in einer allgemeinen Ausführungsform nachfolgende Schritte auf:
- Anordnung der ersten Kontaktfläche in einer ersten X-Y-Ebene und der zweiten Kontaktfläche in einer zweiten, zur ersten X-Y-Ebene parallelen X-Y-Ebene,
- Erfassung von X-Y-Positionen von entlang der ersten Kontaktfläche angeordneten ersten Ausrichtungsschlüsseln in einem ersten, von einer Bewegung des ersten Substrats unabhängigen X-Y-Koordinatensystem durch erste Erfassungsmittel und Erfassung von X-Y-Positionen von entlang der zweiten Kontaktfläche angeordneten zweiten, zu den ersten Ausrichtungsschlüsseln korrespondierenden Ausrichtungsschlüsseln in einem zweiten, von einer Bewegung des zweiten Substrats unabhängigen X-Y-Koordinatensystem durch zweite Erfassungsmittel,
- Ausrichtung der ersten Kontaktfläche in einer auf Grundlage der ersten X-Y-Positionen ermittelten ersten Ausrichtungsposition und Ausrichtung der zweiten Kontaktfläche in einer gegenüberliegend zu der ersten Kontaktfläche liegenden, auf Grundlage der zweiten X-Y-Positionen ermittelten zweiten Ausrichtungsposition,

Die X-,Y- und Z-Ebene beziehungsweise X-, Y- und Z-Richtung sind mit Vorteil jeweils orthogonal zueinander ausgerichtet, um die Berechnung der X-Y-Positionen in den X-Y-Koordinatensystemen zu erleichtern. Es handelt sich mit Vorteil um gleichartige, insbesondere kartesische Koordinatensysteme, vorzugsweise mit gleicher Skalierung.

In einer vorteilhaften Ausgestaltung der Erfindung ist vorgesehen, dass erste X-Y-Positionen von mehr als zwei ersten Ausrichtungsschlüsseln mit korrespondierenden zweiten Ausrichtungsschlüsseln erfassbar und ausrichtbar sind. Mit einer Vielzahl von Ausrichtungsschlüsseln wird die Ausrichtungsgenauigkeit weiter erhöht, insbesondere wenn die X-Y-Positionen jedes der jeweiligen Ausrichtungsschlüssel im Einzelnen bekannt sind und aufgrund der bekannten X-Y-Positionen zueinander die Ausrichtung mit einer minimalen Gesamtabweichung der Summe der, insbesondere quadratischen, Abweichungen jedes Ausrichtungsschlüsselpaares möglich ist beziehungsweise jeweils eine entsprechende Ausrichtungsposition für jedes Substrat berechenbar ist.

Indem erfindungsgemäß die erste und zweite X-Y-Ebene bei der Erfassung der ersten und zweiten X-Y-Positionen identisch sind, insbesondere zusätzlich zumindest quasi-identisch, vorzugsweise identisch, mit einer Kontaktierungsebene der ersten und zweiten Kontaktfläche beim Kontaktieren, wird die Fehleranfälligkeit bei der Kontaktierung in Z-Richtung minimiert beziehungsweise ausgeschlossen. Mit identisch ist eine Abweichung von maximal 20 µm, insbesondere 10 µm, vorzugsweise 5 µm gemeint, die auch für eine etwaige Abweichung der Parallelität der Kontaktflächen zueinander und zu den jeweiligen Plattformen beziehungsweise den Aufnahmeeinrichtungen gilt.

Soweit das erste und/oder das zweite X-Y-Koordinatensystem einer Basis der Vorrichtung zugeordnet sind, die mit Vorteil ortsfest und/oder starr und/oder massiv ausgebildet ist, ermöglicht dies einen zuverlässigen und von Umwelteinflüssen unabhängigen Prozess.

Da der Versatz jedes ersten Ausrichtungsschlüssels zum korrespondierenden zweiten Ausrichtungsschlüssel in X-Y-Richtung ermittelbar ist, kann die individuelle Abweichung bei der Kontaktierung berücksichtigt werden. Hierdurch wird der Produktionsausschuss stark minimiert beziehungsweise die Ausbeute stark erhöht, wodurch die Produktionskosten verringert und die Produktionsgeschwindigkeit erhöht werden.

Ein weiterer Vorteil ergibt sich in einer Ausgestaltung der Erfindung daraus, dass die ersten und/oder die zweiten Erfassungsmittel während der Erfassung und/oder der Ausrichtung und/oder der Kontaktierung, insbesondere mechanisch, fixierbar sind, vorzugsweise an der Basis. Denn durch Ausschluss einer Bewegung der Erfassungsmittel gegenüber dem zugeordneten X-Y-Koordinatensystem werden insofern weitere Fehlerquellen ausgeschlossen.

Mit Vorteil ist bei der erfindungsgemäßen Vorrichtung vorgesehen, dass die Vorrichtung durch Prüfmittel zur Prüfung der Ausrichtung der kontaktierten Substrate kalibrierbar ist. Durch die Prüfmittel sind Rückschlüsse auf die Ausrichtungsqualität und Unterschiede zu der berechneten Ausrichtung möglich. Die Vorrichtung kann daher adaptiv ausgestaltet werden und sich selbst kalibrieren. Die Prüfung kann auch in einer externen Messeinrichtung erfolgen, wobei durch Prüfmittel innerhalb der Vorrichtung der Vorteil besteht, dass etwaige Probleme frühzeitig erkannt werden und entsprechende Maßnahmen ergriffen werden können.

Für die Prüfung kommen speziell auf den Substraten vorgesehene, insbesondere IR-transparente, Prüfungsmarkierungen in Frage, die eine hochgenaue Ermittlung der Abweichung der Substrate ermöglichen.

Zu einer weiteren Fehlerminimierung trägt es bei, dass die ersten Erfassungsmittel in einer vorteilhaften Ausführungsform der Erfindung durch einen einzigen ersten Ausrichtungsschlüsseldetektor und/oder die zweiten Erfassungsmittel durch einen einzigen zweiten Ausrichtungsschlüsseldetektor gebildet sind.

Indem zur parallelen Ausrichtung der ersten und zweiten Kontaktflächen, insbesondere kontaktlos arbeitende, erste und zweite Abstandsmesseinrichtungen sowie Aktuatoren zur Bewegung der Substrate quer zu den X-Y-Ebenen vorgesehen sind, wird eine genaue parallele Ausrichtung der Kontaktflächen zueinander ermöglicht. Weiterhin ermöglicht das Vorsehen von Abstandsmesseinrichtungen die Erkennung von Wölbungen der Substrate.

Die Ausrichtung der Substrate unter Verwendung der exakten Positionsinformationen der Ausrichtungsschlüssel erlaubt eine Berechnung der individuellen Ausrichtung der Substrate mittels mathematischen Modellen, die anwendungsspezifische Kriterien und/oder Parameter berücksichtigen. Eine Optimierung der Ausrichtung kann insbesondere zur Erreichung einer maximalen Ausbeute erfolgen.

Weitere Vorteile, Merkmale und Einzelheiten der Erfindung ergeben sich aus der nachfolgenden Beschreibung bevorzugter Ausführungsbeispiele sowie anhand der Zeichnungen, diese zeigen in:
- Fig. 1a: Eine schematische Darstellung einer Aufsicht auf die erfindungsgemäße Vorrichtung nach dem Beladen und einer Grobausrichtung der Substrate,
- Fig. 1b: eine schematische Schnittansicht gemäß Schnittlinie A-A aus Figur 1a,
- Fig. 2a: eine schematische Aufsicht auf die Vorrichtung beim Keilfehlerausgleich,
- Fig. 2b: schematische Darstellung einer Seitenansicht gemäß Schnittlinie A-A aus Figur 2a am Beginn des Keilfehlerausgleichschrittes,
- Fig. 2c: schematische Darstellung einer Seitenansicht gemäß Schnittlinie A-A aus Figur 2a am Ende des Keilfehlerausgleichschrittes,
- Fig. 2d: Eine schematische Detaildarstellung zum Keilfehlerausgleichschritt,
- Fig. 3a: eine schematische Aufsicht auf die erfindungsgemäße Vorrichtung bei einem Ausrichtungsschlüsselerkennungsschritt,
- Fig. 3b: eine schematische Detailansicht zur Ausrichtungsschlüsselerkennung,
- Fig. 4a: eine schematische Aufsicht auf die erfindungsgemäße Vorrichtung bei der Ausrichtung der Substrate,
- Fig. 4b: schematische Schnittansicht gemäß Schnittlinie A-A aus Figur 4a,
- Fig. 4c: eine schematische Aufsicht auf die erfindungsgemäße Vorrichtung beim Ausrichten der Substrate,
- Fig. 4d: eine schematische Aufsicht auf die erfindungsgemäße Vorrichtung nach dem Ausrichten,
- Fig. 4e: eine schematische Schnittansicht gemäß Schnittlinie A-A aus Figur 4d,
- Fig. 5a: eine schematische Aufsicht auf die erfindungsgemäße Vorrichtung bei einem Schritt zur Ausrichtungsüberprüfung,
- Fig. 5b: eine schematische Schnittansicht gemäß Schnittlinie A-A aus Figur 5a,
- Fig. 6a: eine Aufsicht auf eine alternative Ausführungsform der erfindungsgemäßen Vorrichtung nach Beladen und Grobausrichten der Substrate,
- Fig. 6b: eine schematische Schnittansicht gemäß Schnittlinie A-A aus Figur 6a,
- Fig. 7a: eine schematische Aufsicht auf die alternative Ausführungsform bei einem Keilfehlerausgleichsschritt,
- Fig. 7b: eine schematische Schnittansicht gemäß Schnittlinie A-A aus Figur 7a,
- Fig. 7c: eine schematische Aufsicht auf die erfindungsgemäße Ausführungsform bei einem Keilfehlerausgleichsschritt,
- Fig. 7d: eine schematische Schnittansicht gemäß Schnittlinie A-A aus Figur 7c,
- Fig. 7e: eine Detailansicht zum Schritt des Keilfehlerausgleichs,
- Fig. 8a und 8b: eine schematische Aufsicht auf die alternative Ausführungsform bei der Ausrichtungsschlüsselerfassung,
- Fig. 8c: eine schematische Detailansicht der Ausrichtungsschlüsselerfassung,
- Fig. 9a: eine schematische Darstellung der alternativen Ausführungsform bei der Ausrichtung der Substrate,
- Fig. 9b: eine schematische Schnittansicht gemäß Schnittlinie A-A aus Figur 9a,
- Fig. 9c: eine schematische Schnittdarstellung der alternativen Ausführungsform nach dem kontaktieren in einer Z-Richtung,
- Fig. 10a: eine schematische Aufsicht auf die alternative Ausführungsform bei einem Ausrichtungsprüfschritt und
- Fig. 10b: eine schematische Schnittansicht gemäß Schnittlinie A-A aus Figur 10a.

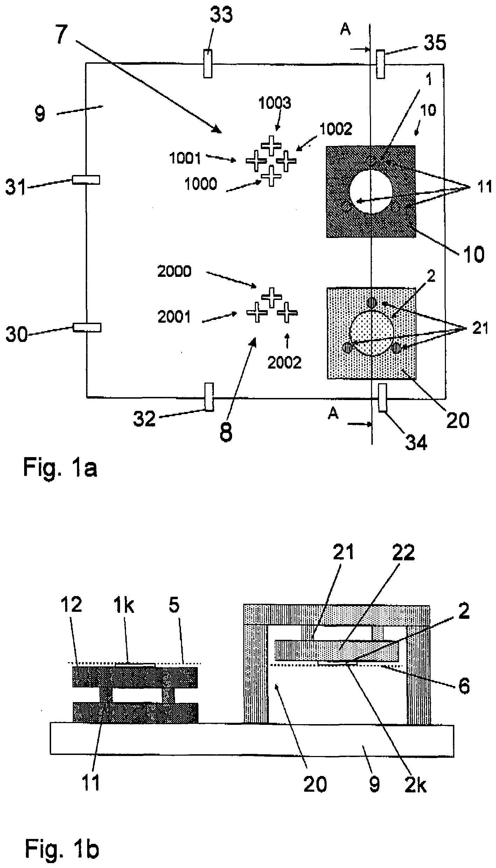

In den Figuren 1a und 1b ist eine Basis 9 dargestellt, auf der eine erste Plattform 10 und eine zweite Plattform 20, insbesondere durch Luftlagerung, beweglich aufgenommen sind. Die Basis 9 ist mit Vorteil aus einem ortsfesten und/oder massiven und/oder starren Material, insbesondere Granit gebildet. Die Bewegung der ersten und zweiten Plattform 10, 20, insbesondere ausschließlich, in einer X- und einer Y-Richtung kann durch Antriebsmittel, insbesondere Linearmotoren, erfolgen, die an der Außenkontur der Basis 9 angeordnet sind. Jeder der ersten und zweiten Plattformen 10, 20 ist eine eigene Antriebseinheit zugeordnet.

Die Antriebseinheit ist in stabiler, nicht flexibler Weise mit der ihr zugeordneten ersten oder zweiten Plattform 10, 20 verbunden, um die Antriebskräfte fehlerfrei und hochgenau auf die erste oder zweite Plattform 10, 20 zu übertragen. Die Antriebseinheiten weisen eine maximale Abweichung von <25nm, insbesondere <15nm,, vorzugsweise <5nm, auf.

Auf der ersten Plattform 10 ist ein erstes Substrat 1, insbesondere ein Wafer, aufgenommen und flächig, insbesondere durch Unterdruck, fixiert.

Ein zweites Substrat 2, insbesondere ebenfalls ein Wafer, ist auf der zweiten Plattform 20 aufnehmbar und fixierbar.

Beide Substrate 1, 2 werden in einem Beladeschritt durch nicht gezeigte Belademittel, insbesondere Roborterarme, auf die beiden Plattformen 10, 20 geladen. Das erste Substrat 1 weist eine von der ersten Plattform 10 abgewandte erste Kontaktfläche 1k zur Kontaktierung einer von der zweiten Plattform 20 abgewandten zweiten Kontaktfläche 2k des zweiten Substrats 2 auf.

Die Aufnahme der Substrate 1, 2 auf den Plattformen 10, 20 erfolgt jeweils durch geeignete Aufnahmemittel 12, 22, beispielsweise Chucks. Die temporäre Fixierung der Substrate 1, 2 erfolgt durch geeignete Fixiermittel, insbesondere durch Unterdruck. Die Substrate 1, 2 sind damit ortsfest in Bezug auf die Plattformen 10, 20.

Zur Bewegung der Aufnahmemittel 12, 22 in einer Z-Richtung, insbesondere auch zum Ausgleich eines Keilfehlers, sind drei Aktuatoren 11 an der vom ersten Substrat 1 abgewandten Seite des Aufnahmemittels 12 über die Fläche des Aufnahmemittels 12 verteilt angeordnet. Analog gilt dies für Aktuatoren 21 zur Bewegung der Aufnahmemittel 22 in einer Z-Richtung, insbesondere für einen Keilfehlerausgleichschritt, der weiter unten beschrieben ist.

Beim Aufbringen der Substrate 1, 2 auf die Aufnahmemittel 12, 22 erfolgt eine grobe Ausrichtung durch erste und zweite Mikroskope 1001, 2001, sodass die Substrate 1, 2 auf den Aufnahmemitteln 12, 22 in X- und Y-Richtung beziehungsweise zusätzlich in Rotationsrichtung vorpositioniert aufgenommen werden.

Die erste Kontaktfläche 1k bildet eine erste X-Y-Ebene 5 und die zweite Kontaktfläche 2k bildet eine zweite X-Y-Ebene 6, die bei der vorliegenden Ausführungsform zumindest bei der Erfassung der Ausrichtungsschlüssel in etwa zusammenfallen. Die maximale Abweichung der Ebenen soll - auch im Hinblick auf deren Parallelität - kleiner 20µm, insbesondere 10 µm, vorzugsweise 5 µm, betragen. Darüber hinaus sind die erste X-Y-Ebene 5 und die zweite X-Y-Ebene 6 - insbesondere mit den vorgenannten maximalen Abweichungen - jeweils parallel zur Auflagefläche der Basis 9. Hierdurch werden Fehler bei der Bewegung der Substrate 1, 2 in Z-Richtung, beispielsweise beim Kontaktieren der Substrate minimiert beziehungsweise vermieden.

Der ersten Plattform 10 zugeordnete erste Erfassungsmittel 7 umfassen das Mikroskop 1001, einen Ausrichtungsschlüsseldetektor 1000, Abstandsmessmittel 1002 und einen Prüfungsdetektor 1003. Der Prüfungsdetektor 1003 dient zur Überprüfung und gegebenenfalls Selbstkalibrierung der erfindungsgemäßen Vorrichtung nach der Kontaktierung der Substrate 1 und 2.

Der zweiten Plattform 20 sind zweite Erfassungsmittel 8 zugeordnet, die einen Ausrichtungsmitteldetektor 2000, optische Erfassungsmittel 2001 und Abstandsmessmittel 2002 für das zweite Substrat 2 umfassen.

Am Umfang beziehungsweise im Bereich der Außenkontur der Basis 9 sind Positionserfassungsmittel 30, 31, 32, 33, 34, 35, insbesondere Laserinterferometer, angeordnet und fixiert, die zur exakten Bestimmung der Position der ersten Plattform 10 und/oder der zweiten Plattform 20 vorgesehen sind.

Die Positionserfassungsmittel 30, 31, 32, 33, 34, 35 weisen eine Erfassungsgenauigkeit von <25nm, insbesondere <5nm, vorzugsweise <lnm auf, so dass etwaige Fehler der Positionserfassung auf die Ausrichtungsgenauigkeit quasi keine Auswirkung haben, zumal das System selbst kalibrierend ausgebildet sein kann.

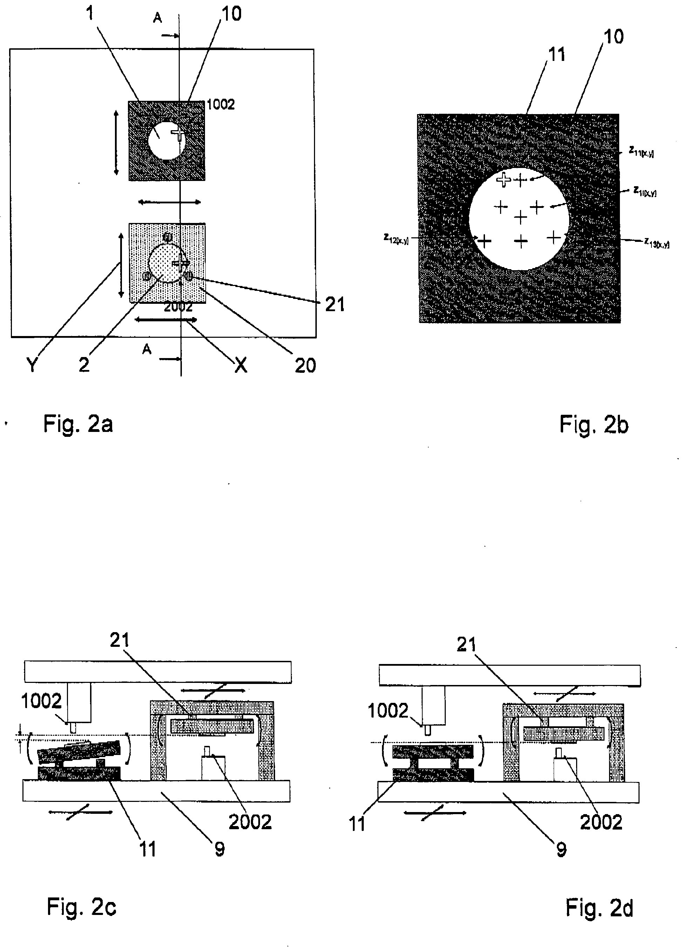

In den Figuren 2a bis 2d ist der sich vorzugsweise an die Vorpositionierung der Substrate 1, 2 anschließende Schritt des Keilfehlerausgleichs durch Keilfehlerausgleichmittel dargestellt. Zur Erfassung der vertikalen Position der ersten Kontaktfläche 1k des ersten Substrats 1 wird die erste Plattform 10 gemäß Figur 2a unter den Abstandsdetektor 1002 bewegt und dort werden die Abstände mehrerer über die Fläche des ersten Substrats verteilter Messpunkte (siehe Figur 2d) gemessen, um einen eventuellen Keilfehler zu erkennen und auszugleichen. Ebenso wird mit dem zweiten Substrat 2 und dem entsprechenden Abstandsdetektor 2002 verfahren.

Anschließend wird der Keilfehler durch entsprechende Bewegung der Aktuatoren 11 für das erste Substrat 1 gemäß Figur 2b und der Aktuatoren 21 für die parallele Ausrichtung des zweiten Substrats 2 gemäß Figur 2c ausgeglichen. Die Kontaktflächen 1k und 2k sind anschließend parallel, ebenso die X-Y-Ebenen 5 und 6, die vorzugsweise eine einzige Ebene bilden (siehe Figur 2c). Die Parallelität soll die oben genannte Genauigkeit aufweisen.

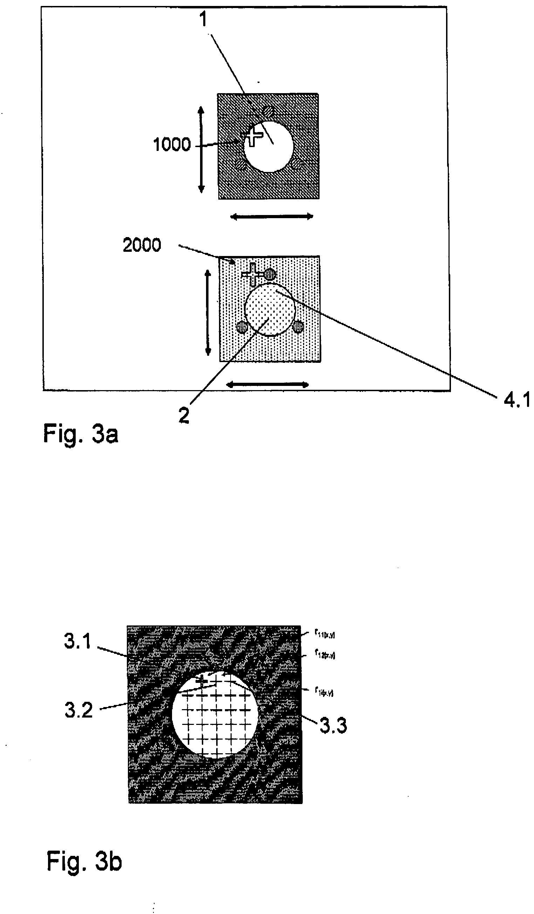

Insbesondere im Anschluss an den Keilfehlerausgleich werden eine Vielzahl erster Ausrichtungsschlüssel 3.1 bis 3.n gemäß Figur 3b durch jeweils der ersten und zweiten Plattform 10, 20 zugeordnete Ausrichtungsschlüsseldetektoren 1000, 2000 detektiert, und zwar deren X- und Y-Koordinaten in einem ersten X-Y-Koordinatensystem der ersten Plattform 10 für die ersten Ausrichtungsschlüssel 3.1 bis 3.n sowie einem zweiten X-Y-Koordinatensystem der zweiten Plattform 20 für zweite Ausrichtungsschlüssel 4.1 bis 4.n.

Das erste X-Y-Koordinatensystem ist der ersten Plattform 10 und damit dem hierauf fixierten ersten Substrat 1 zugeordnet und das zweite X-Y-Koordinatensystem ist der zweiten Plattform 20 und damit dem hierauf fixierten zweiten Substrat 2 zugeordnet, so dass die X-Y-Positionen der ersten und zweiten Ausrichtungsschlüssel 3.1 bis 3.n, 4.1 bis 4.n durch Bewegung der ersten und zweiten Substrate 1, 2 im jeweiligen X-Y-Koordinatensystem erfasst werden kann, da die X-Y-Koordinatensysteme unabhängig von der Bewegung der Substrate 1, 2 sind. Mit Vorteil handelt es sich bei beiden um ein kartesisches Koordinatensystem mit identischer Skalierung.

Nach dem Schritt der Ausrichtungsschlüsselerfassung sind demnach die jeweils in Bezug auf die Basis 9 bezogene X-Y-Positionen der ersten und zweiten Ausrichtungsschlüssel 3.1 bis 3.n, 4.1 bis 4.n als absolute Position innerhalb der Vorrichtung bekannt und diese ändern sich in Relation zu den Plattformen 10, 20 während des Verfahrens nicht mehr.

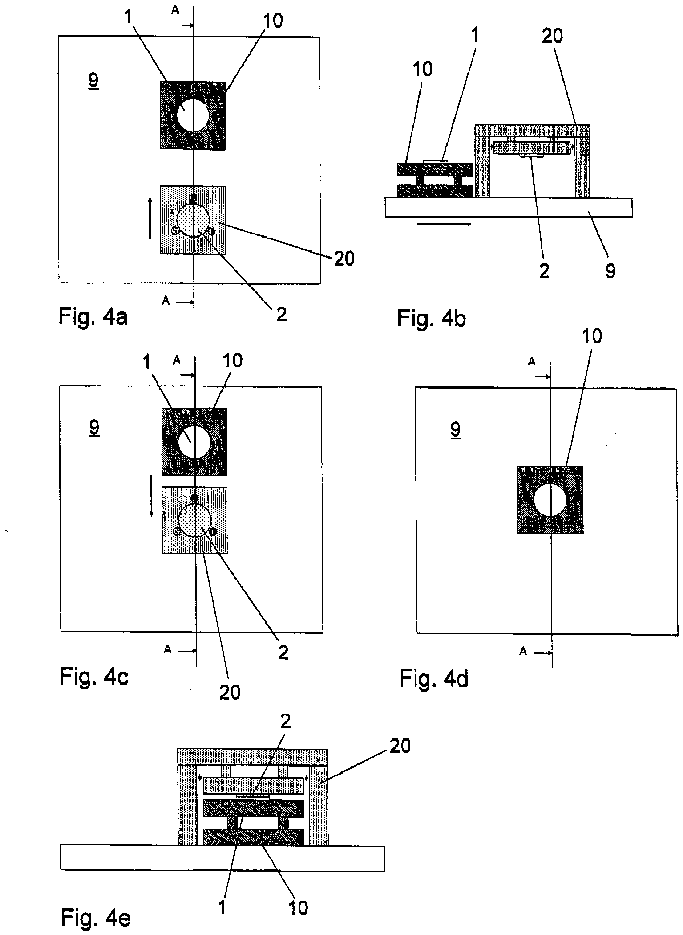

In den Figuren 4a bis 4e ist der sich an die Erfassung der Ausrichtungsschlüssel 3.1 bis 3.n und 4.1 bis 4.n anschließende Schritt der exakten Ausrichtung und in Figur 4e der Kontaktierung der beiden Substrate 1, 2 dargestellt. Gemäß Figuren 4a bis 4d werden die erste und zweite Plattform 10, 20 jeweils in die auf Grundlage der vorher bestimmten X-Y-Positionen der ersten und zweiten Ausrichtungsschlüssel 3.1 bis 3.n, 4.1 bis 4.n berechnete jeweilige erste und zweite Ausrichtungsposition gefahren, was auf Grundlage der bekannten X-Y-Positionen der ersten und zweiten Plattformen 10, 20 möglich ist.

Bei der Berechnung der Ausrichtungsposition kann durch mathematische Verteilungsberechnung der Ausrichtungsschlüssel 3.1 bis 3.n und 4.1 bis 4.n jeweils eine Ausrichtungsposition mit geringst möglichem Abstand der jeweils korrespondierenden ersten zu den jeweils korrespondierenden zweiten Ausrichtungsschlüsseln 3.1 bis 3.n, 4.1 bis 4.n berechnet werden. Beispielsweise kann die Summe der Abstände beziehungsweise die Summe der quadratischen Abstände auf ein Minimum reduziert werden oder andere bekannte mathematische Modelle zur Anwendung kommen. Insbesondere kann die Ausrichtung so vorgenommen werden, dass eine möglichst hohe ausrichtungsgenauigkeitsabhängige Ausbeute möglich wird.

Bevor die Substrate 1, 2 in die in Figur 4d gezeigte Position gefahren werden, ist eine möglichst geringfügige Bewegung zumindest eines der beiden Substrate 1, 2 von dem anderem in einer Z-Richtung weg erforderlich, vorzugsweise des Substrats 2 durch Aktuatoren 21, insbesondere durch gleichmäßige Bewegung der Aktuatoren 21. Etwaige Fehler bei der Bewegung der Substrate in Z-Richtung werden kompensiert, da die gleiche Bewegung in entgegengesetzte Richtung zur Kontaktierung gemäß Figur 4e ausgeführt wird. Dies wird ermöglicht, indem die Erfassung der Ausrichtungsschlüssel 3.1 bis 3.n, 4.1 bis 4.n gemäß Figuren 3a und 3b und/oder durch den Schritt des Keilfehlerausgleichs gemäß Figuren 2a bis 2d derart erfolgt, dass die erste und zweite X-Y-Ebene 5, 6 und damit die erste und zweite Kontaktfläche 1k, 2k in ein und derselben Ebene angeordnet sind.

Nach Kontaktierung gemäß Figur 4e werden die Substrate 1 und 2 fixiert, beispielsweise durch bekannte Klemmmechanismen oder durch Bonden.

Im Anschluss an die Kontaktierung und Fixierung der Substrate 1, 2 erfolgt optional eine Überprüfung der Kontaktierungsqualität, das heißt der Ausrichtung der Substrate 1, 2 zueinander durch Prüfungsdetektoren 1003, vorzugsweise in Form einer Infrarotmessung, die die relative Position von entsprechenden Prüfschlüsseln oder der Ausrichtungsschlüssel 3.1 bis 3.n, 4.1 bis 4.n auf dem ersten Substrat 1 und dem zweiten Substrat 2 überprüft. Das Ergebnis ist mit der vorher berechneten Ausrichtung vergleichbar und auf Grundlage des Vergleichs kann das Substratpaar gegebenenfalls als Ausschuss qualifiziert werden und/oder basierend auf den ermittelten Informationen einer geeigneten Nachbearbeitung zugeführt. Weiterhin ist es möglich, die Vorrichtung selbstlernend auszuführen, indem die Relation des ersten zum zweiten X-Y-Koordinatensystem berichtigt oder kalibriert wird.

Anschließend kann das kontaktierte und fixierte Substratpaar aus erstem Substrat 1 und zweitem Substrat 2 von der Ausrichtungsvorrichtung entladen werden, insbesondere durch nicht dargestellte Belademittel.

Die Keilfehlerausgleichsmittel können in einer alternativen Ausführungsform derart ausgebildet sein, dass eine Gleichförmigkeitskarte der Kontaktflächen 1k, 2k der Substrate 1, 2 berechnet wird. Gleichzeitig oder alternativ hierzu kann durch eine Vielzahl von Aktuatoren 11, 21 auf die Gleichförmigkeit, insbesondere Ebenheit, der Kontaktflächen 1k, 2k Einfluss genommen werden, indem eine flexible Oberfläche an den Aufnahmemitteln 12, 22 vorgesehen ist.

Ein weiterer Vorteil der erfindungsgemäßen Vorrichtung besteht darin, dass während der Verarbeitung eines Substratpaares bereits mit dem nächsten zu verarbeitenden Substratpaar begonnen werden kann, sodass eine parallele Bearbeitung ermöglicht wird. Hierdurch wird der Durchsatz deutlich erhöht.

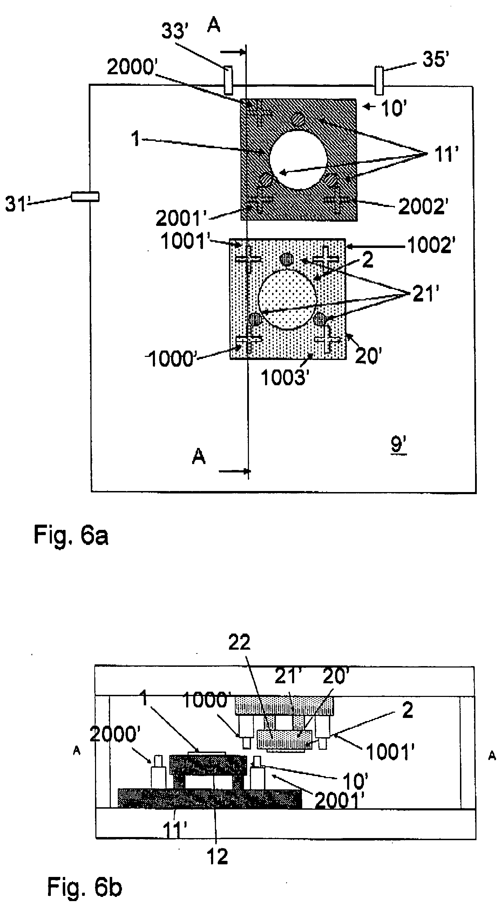

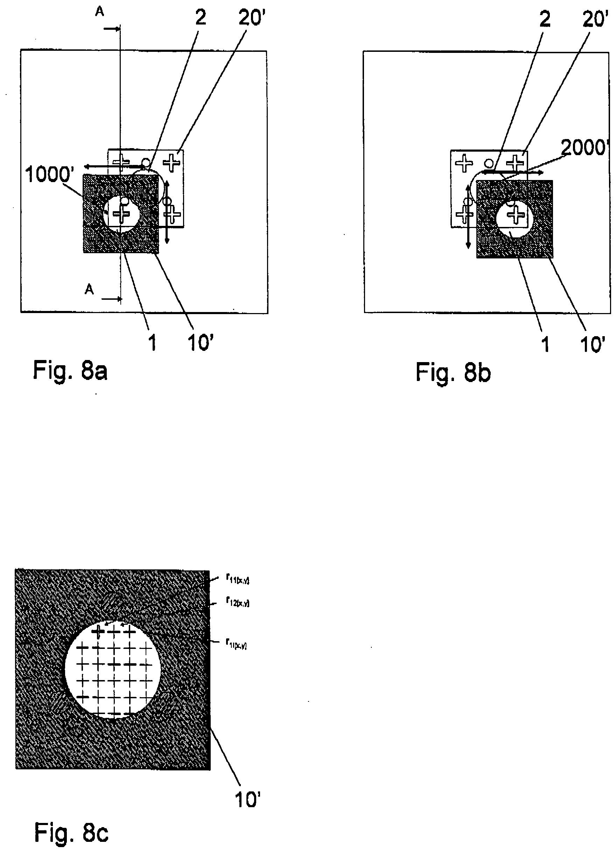

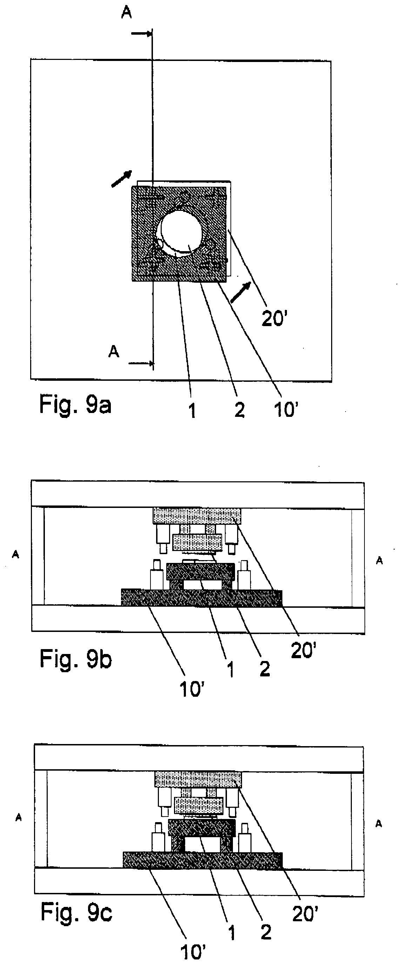

Die Figuren 6a bis 10b betreffen eine alternative Ausführungsform, bei der im Unterschied zur vorbeschriebenen Ausführungsform nur eine der beiden Plattformen 10', 20', im konkret gezeigten Fall die Plattform 10' beweglich ausgebildet ist. Der Vorteil dieser Ausführungsform liegt in der einfacheren Ausführung, der kleineren Standfläche und den geringeren Herstellungskosten. Denn für die Bewegung werden lediglich drei Antriebsmotoren statt fünf bei der vorbeschriebenen Ausführungsform, nämlich ein Antriebsmotor für die Bewegung in X-Richtung, einer für die Bewegung in Y-Richtung und einer für die Rotation benötigt. Bei der vorbeschriebenen Ausführungsform werden zusätzlich zwei Antriebsmotoren, nämlich einer für die Bewegung der zweiten Plattform 20 in X-Richtung und einer für die Bewegung der zweiten Plattform 20 in Y-Richtung benötigt.

Entsprechend werden nur drei Positionserfassungsmittel 31', 33' und 35' statt sechs bei der vorbeschriebenen Ausführungsform benötigt.

Der Ablauf des Verfahrens ist ähnlich wie bei der vorbeschriebenen Ausführungsform, wobei die Bewegungen der zweiten Plattform 20 bei der alternativen Ausführungsform mit starrer zweiter Plattform 20' durch die Bewegung der zweiten Erfassungsmittel 8', nämlich Ausrichtungsschlüsseldetektor 2000' und optische Erfassungsmittel 2001' mit der ersten Plattform 10' kompensiert wird beziehungsweise ersetzt werden.

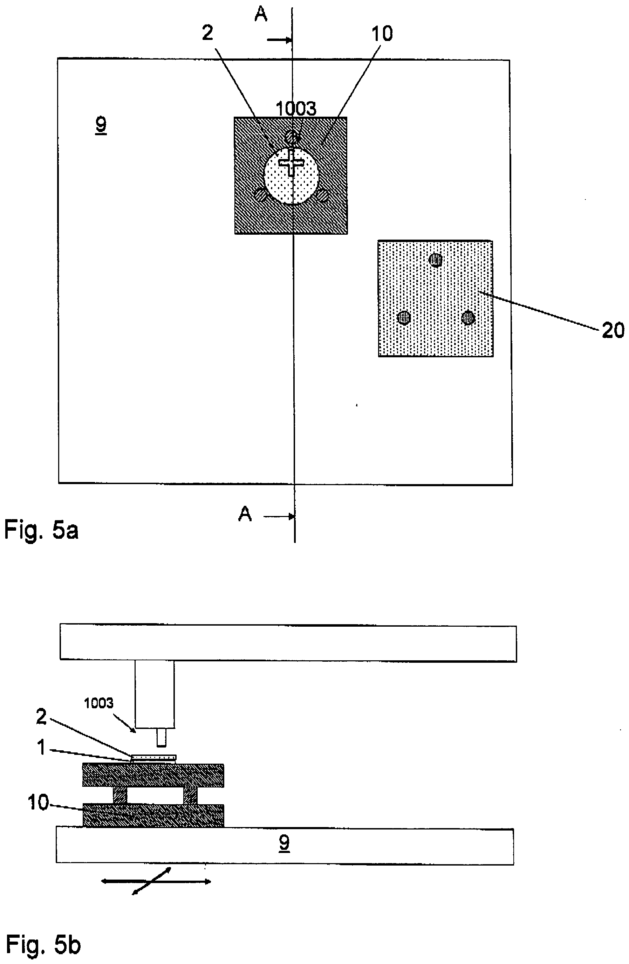

Soweit die Funktion einzelner, in den Figuren 6a bis 10b beschriebener Bauteile nicht explizit beschrieben wird, ist diese entsprechend der vorbeschriebenen Ausführungsform gemäß Figuren 1a bis 5b und umgekehrt.

In Figur 6a ist das erste Substrat 1 auf der ersten Plattform 10' und das zweite Substrat 2 auf der zweiten Plattform 20' aufgenommen, nämlich auf Aufnahmemitteln 12, 22. Die Positionen der ersten und zweiten Ausrichtungsschlüssel 3.1 bis 3.n beziehungsweise 4.1 bis 4.n wurden dabei durch niedrig auflösende optische Erfassungsmittel 1001', 2001' entsprechend grob vorausgerichtet.

Während die zweiten Erfassungsmittel 8', bestehend aus dem Ausrichtungsmitteldetektor 2000', dem optischen Erfassungsmittel 2001' und einem Abstandsmessmittel 2002', auf der ersten Plattform 10' in einer definierten Position fixiert angeordnet sind, befinden sich die ersten Erfassungsmittel 7', bestehend aus dem Ausrichtungsschlüsseldetektor 1000', dem optischen Erfassungsmittel 1001', einem Abstandsmessmittel 1002' und Prüfungsdetektoren 1003' auf der zweiten Plattform 20', sodass die Erfassungsmittel 7', 8' jeweils gegenüberliegend zu dem jeweils zu messenden Substrat 1, 2 anordenbar sind.

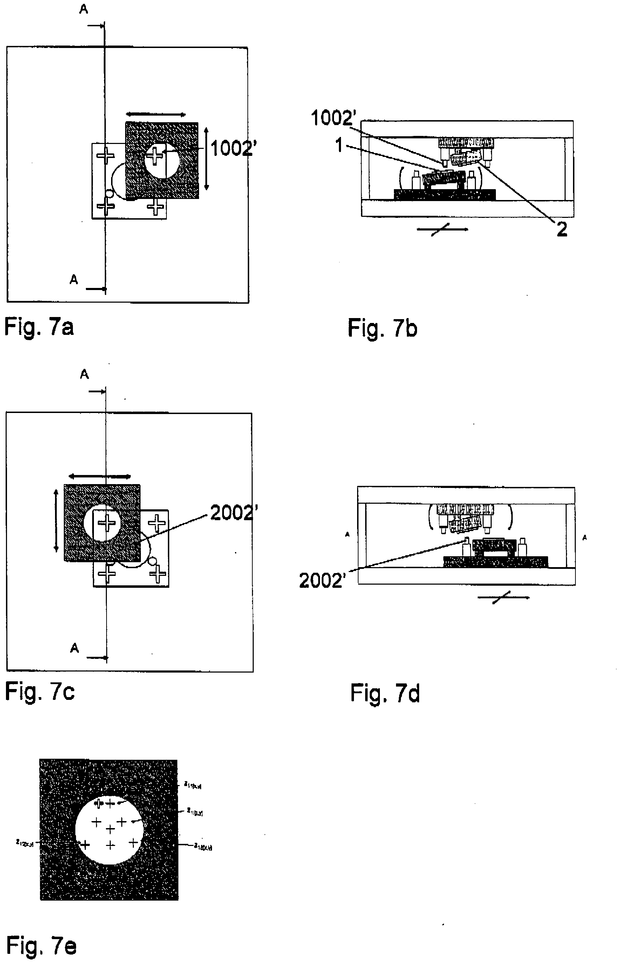

Bei der in Figuren 7a bis 7e dargestellten Keilfehlerkorrektur wird die erste Kontaktfläche 1k an verschiedenen Positionen gemäß Figur 7e durch Bewegung der ersten Plattform 10' zu dem auf der zweiten Plattform 20' fixiert angeordneten Abstandsmessmittel 1002' bewegt und bemessen. Anschließend erfolgt die Messung des Abstands von Messpunkten auf der zweiten Kontaktfläche 2k durch Bewegung des auf der ersten Plattform 10' angeordneten Abstandsmessmittels 2002'.

Aufgrund der gemessenen Verteilung können die erste Kontaktfläche 1k und die zweite Kontaktfläche 2k durch entsprechende Bewegung der Aktuatoren 11 und 21 parallel zueinander ausgerichtet werden.

Dabei weisen die parallelen ersten und zweiten X-Y-Ebenen 5, 6 einen geringfügigen Abstand auf, sind aber bei dieser Ausführungsform nicht in der gleichen Ebene.

Anschließend werden erste Ausrichtungsschlüssel 3.1 bis 3.n des ersten Substrats 1 mittels des an der zweiten Plattform 20' angebrachten Ausrichtungsschlüsseldetektors 1000' detektiert, und zwar deren absolute Positionen im ersten X-Y-Koordinatensystem. Aus den detektierten Koordinaten werden ein lineares oder nicht lineares mathematisches Verteilungsmodell und/oder entsprechende Modellparameter berechnet, wie bei der Ausführungsform gemäß Figuren 1a bis 5b.

Anschließend werden die zweiten Ausrichtungsschlüssel 4.1 bis 4.n des zweiten Substrats 2 mittels des auf der ersten Plattform 10' fixierten Ausrichtungsschlüsseldetektors 2000' detektiert und deren Koordinaten in dem zweiten X-Y-Koordinatensystem erfasst. Aus den erfassten Koordinaten werden entsprechend ein lineares oder nicht-lineares mathematisches Verteilungsmodell und/oder Modellparameter berechnet beziehungsweise angenähert.

Aus den Modellparametern beziehungsweise dem mathematischen Verteilungsmodell der ersten und zweiten Ausrichtungsschlüssel 3.1 bis 3.n beziehungsweise 4.1 bis 4.n und den durch Positionserfassungsmittel 31', 33' und 35', insbesondere Laserinterferometer, bekannten Positionen sowie der Relation der ersten Plattform 10' zur zweiten Plattform 20' sowie der bekannten Positionen der Ausrichtungsschlüsseldetektoren 1000' und 2000' im jeweiligen X-Y-Koordinatensystem kann die Ausrichtungsposition der ersten Plattform 10' berechnet werden, um die Substrate 1 und 2 entsprechend auszurichten.

Nach Ausrichtung wird das Substrat 1 durch die Aktuatoren 11 in Z-Richtung in Kontakt mit dem Substrat 2 gebracht.

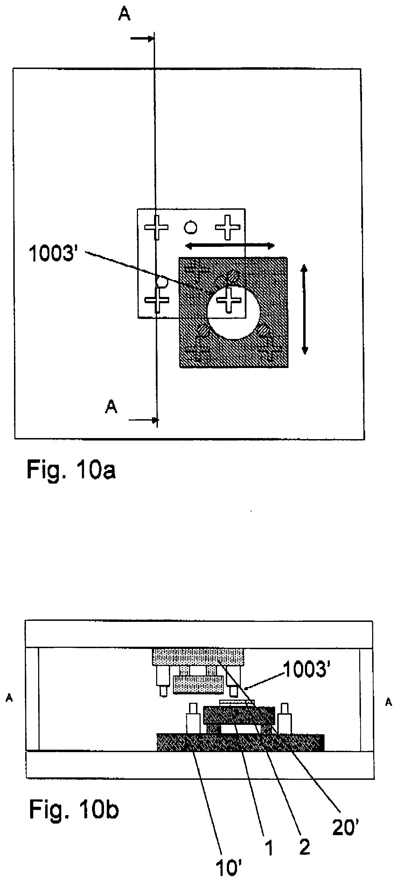

Durch an der zweiten Plattform 20' angebrachte Prüfungsdetektoren 1003' wird die Qualität der Ausrichtung und Kontaktierung des Substratpaares gemäß Figur 10a und Figur 10b ermittelt,

Durch die vorbeschriebenen Ausführungsformen werden erheblich größere Ausrichtungsgenauigkeiten erreicht, insbesondere über die Kontaktflächen 1k, 2k verteilt und im Hinblick auf die einzelnen Positionen der Ausrichtungsschlüssel, insbesondere Chips, sodass eine Ausrichtungsgenauigkeit von < 250 nm, insbesondere < 150 nm, vorzugsweise < 70nm erreicht werden kann.

### Bezugszeichenliste

- 1: erstes Substrat
- 1k: erste Kontaktfläche
- 2: zweites Substrat
- 2k: zweite Kontaktfläche
- 3.1 bis 3.n: erste Ausrichtungsschlüssel
- 4.1 bis 4.n: zweite Ausrichtungsschlüssel
- 5: erste X-Y-Ebene
- 6: zweite X-Y-Ebene
- 7, 7': erste Erfassungsmittel
- 8, 8': zweite Erfassungsmittel
- 9, 9': Basis
- 10, 10': erste Plattform
- 11: Aktuatoren
- 12: Aufnahmemittel
- 20, 20': zweite Plattform
- 21: Aktuatoren
- 22: Aufnahmemittel
- 30: Positionserfassungsmittel
- 31, 31': Positionserfassungsmittel
- 32: Positionserfassungsmittel
- 33, 33': Positionserfassungsmittel
- 34: Positionserfassungsmittel
- 35, 35': Positionserfassungsmittel

- 1000, 1000': Ausrichtungsschlüsseldetektor
- 2000, 2000': Ausrichtungsschlüsseldetektor
- 1001, 1001': optische Erfassungsmittel
- 2001, 2001': optische Erfassungsmittel
- 1002, 1002': Abstandsmessmittel
- 2002, 2002': Abstandsmessmittel
- 1003, 1003': Prüfungsdetektoren

## Patentansprüche

1. Vorrichtung zum Ausrichten einer ersten Kontaktfläche (1k) eines auf einer ersten Plattform (10) aufnehmbaren ersten Substrats (1) mit einer zweiten Kontaktfläche (2k) eines auf einer zweiten Plattform (20) aufnehmbaren zweiten Substrats (2) mit folgenden Merkmalen:
- erste X-Y-Positionen von entlang der ersten Kontaktfläche (1k) angeordneten ersten Ausrichtungsschlüsseln (3.1 bis 3.n) sind in einer Erfassungsposition durch erste Erfassungsmittel (7, 7') in einer ersten X-Y-Ebene (5) in einem ersten, von einer Bewegung des ersten Substrats (1) unabhängigen X-Y-Koordinatensystem erfassbar,
- zweite X-Y-Positionen von entlang der zweiten Kontaktfläche (2k) angeordneten, zu den ersten Ausrichtungsschlüsseln (3.1 bis 3.n) korrespondierenden zweiten Ausrichtungsschlüsseln (4.1 bis 4.n) sind in der Erfassungsposition durch zweite Erfassungsmittel (8, 8') in einer zweiten, zur ersten X-Y-Ebene (5) parallelen X-Y-Ebene (6) in einem zweiten, von einer Bewegung des zweiten Substrats (2) unabhängigen X-Y-Koordinatensystem erfassbar,
- in der Erfassungsposition sind durch Positionserfassungsmittel (30, 31, 31', 32, 33, 33', 34, 35, 35') die Positionen der Substrate (1, 2) erfassbar,
- die erste Kontaktfläche (1k) ist auf Grundlage der ersten X-Y-Positionen in einer ersten Ausrichtungsposition und die zweite Kontaktfläche (2k) ist auf Grundlage der zweiten X-Y-Positionen in einer zweiten Ausrichtungsposition ausrichtbar,
**dadurch gekennzeichnet, dass** die erste und zweite X-Y-Ebene (5, 6) bei der Erfassung der ersten und zweiten X-Y-Positionen identisch sind, wobei eine Abweichung der Ebenen voneinander von maximal 20µm umfasst ist.

2. Vorrichtung nach Anspruch 1, **dadurch gekennzeichnet, dass** erste X-Y-Positionen von mehr als zwei ersten Ausrichtungsschlüsseln (3.1. bis 3.n) mit korrespondierenden zweiten Ausrichtungsschlüsseln (4.1 bis 4.n) erfassbar und ausrichtbar sind.

3. Vorrichtung nach einem der vorhergehenden Ansprüche, **dadurch gekennzeichnet, dass**, die erste und zweite X-Y-Ebene 5, 6) zusätzlich zumindest quasi-identisch, vorzugsweise identisch, mit einer Kontaktierungsebene der ersten und zweiten Kontaktfläche (1k, 2k) beim Kontaktieren sind.

4. Vorrichtung nach einem der vorhergehenden Ansprüche, **dadurch gekennzeichnet, dass** das erste und/oder das zweite X-Y-Koordinatensystem einer Basis (9) der Vorrichtung zugeordnet sind.

5. Vorrichtung nach einem der vorhergehenden Ansprüche, **dadurch gekennzeichnet, dass** die ersten und/oder die zweiten Erfassungsmittel (7, 7', 8, 8') während der Erfassung und/oder der Ausrichtung und/oder der Kontaktierung, insbesondere mechanisch, fixierbar sind, vorzugsweise an der Basis (9).

6. Vorrichtung nach einem der vorhergehenden Ansprüche, **dadurch gekennzeichnet, dass** die Vorrichtung durch Prüfmittel zur Prüfung der Ausrichtung der kontaktierten Substrate (1, 2) kalibrierbar ist.

7. Vorrichtung nach einem der vorhergehenden Ansprüche, **dadurch gekennzeichnet, dass** das erste und das zweite X-Y-Koordinatensystem kartesische Koordinatensysteme sind und/oder eine identische Skalierung aufweisen und/oder zusammenfallen.

8. Vorrichtung nach einem der vorhergehenden Ansprüche, **dadurch gekennzeichnet, dass** die ersten Erfassungsmittel (7, 7') einen, insbesondere einzigen, ersten Ausrichtungsschlüsseldetektor (1000, 1000') und/oder die zweiten Erfassungsmittel (8, 8') einen, insbesondere einzigen, zweiten Ausrichtungsschlüsseldetektor (2000, 2000') aufweisen.

9. Vorrichtung nach einem der vorhergehenden Ansprüche, **dadurch gekennzeichnet, dass** zur parallelen Ausrichtung der ersten und zweiten Kontaktflächen (1k, 2k), insbesondere kontaktlos arbeitende, erste und zweite Abstandsmesseinrichtungen (1002, 2002) sowie Aktuatoren (11, 21) zur Bewegung der Substrate (1, 2) quer zu den X-Y-Ebenen (5, 6) vorgesehen sind.

10. Verfahren zum Ausrichten einer ersten Kontaktfläche (1k) eines auf einer ersten Plattform (10) aufnehmbaren ersten Substrats (1) mit einer zweiten Kontaktfläche (2k) eines auf einer zweiten Plattform (20) aufnehmbaren zweiten Substrats (2) mit folgenden Schritten:
- Anordnung der ersten Kontaktfläche (1k) in einer ersten X-Y-Ebene und der zweiten Kontaktfläche (2k) in einer zweiten, zur ersten X-Y-Ebene parallelen X-Y-Ebene,
- Erfassung von X-Y-Positionen in einer Erfassungsposition von entlang der ersten Kontaktfläche (1k) angeordneten ersten Ausrichtungsschlüsseln (3.1 bis 3.n) in einem ersten, von einer Bewegung des ersten Substrats (1) unabhängigen X-Y-Koordinatensystem durch erste Erfassungsmittel (7, 7') und Erfassung von X-Y-Positionen von entlang der zweiten Kontaktfläche (2k) angeordneten zweiten, zu den ersten Ausrichtungsschlüsseln (3.1 bis 3.n) korrespondierenden Ausrichtungsschlüsseln (4.1 bis 4.n) in einem zweiten, von einer Bewegung des zweiten Substrats (2) unabhängigen X-Y-Koordinatensystem durch zweite Erfassungsmittel (8, 8'),
- Erfassung in der Erfassungsposition der Positionen der Substrate durch Positionserfassungsmittel (30, 31, 31', 32, 33, 33', 34, 35, 35'),
- Ausrichtung der ersten Kontaktfläche (1k) in einer auf Grundlage der ersten X-Y-Positionen ermittelten ersten Ausrichtungsposition und Ausrichtung der zweiten Kontaktfläche (2k) in einer gegenüberliegend zu der ersten Kontaktfläche (1k) liegenden, auf Grundlage der zweiten X-Y-Positionen ermittelten zweiten Ausrichtungsposition,
**dadurch gekennzeichnet, dass** die erste und zweite X-Y-Ebene (5, 6) bei der Erfassung der ersten und zweiten X-Y-Positionen identisch sind, wobei eine Abweichung der Ebenen voneinander von maximal 20 µm umfasst ist.

## Claims

1. A device for the alignment of a first contact surface (1k) of a first substrate (1) which can be mounted on a first platform (10) with a second contact surface (2k) of a second substrate (2) which can be mounted on a second platform (20) with the following features:
- first X-Y positions of first alignment keys (3.1 to 3.n) arranged along the first contact surface (1k) can be detected in a detection position by first detection means (7, 7') in a first X-Y plane (5) in a first X-Y coordinate system independent of a movement of the first substrate (1),
- second X-Y positions of second alignment keys (4.1 to 4.n) arranged along the second contact surface (2k) and corresponding to the first alignment means (3.1 to 3.n) can be detected in the detection position by second detection means (8, 8') in a second X-Y plane (6) parallel to the first X-Y plane (5) in a second X-Y coordinate system independent of a movement of the second substrate (2),
- the positions of the substrates (1, 2) can be detected in the detection position by position detection means (30, 31, 31', 32, 33, 33', 34, 35, 35'),
- the first contact surface (1k) can be aligned on the basis of the first X-Y positions in a first alignment position and the second contact surface (2k) can be aligned on the basis of the second X-Y positions in a second alignment position,
**characterised in that** the first and second X-Y plane (5, 6) are identical during the detection of the first and second X-Y positions,
wherein a divergence of the planes from one another of at most 20 µm is included.

2. The device according to claim 1, **characterised in that** first X-Y positions of more than two first alignment keys (3.1 to 3.n) can be detected and aligned with corresponding second alignment keys (4.1 to 4.n).

3. The device according to any one of the preceding claims, **characterised in that** the first and second X-Y plane (5, 6) are in addition at least almost identical, preferably identical, to a contacting plane of the first and second contact surface (1k, 2k) when contact takes place.

4. The device according to any one of the preceding claims, **characterised in that** the first and/or the second X-Y coordinate system are assigned to a base (9) of the device.

5. The device according to any one of the preceding claims, **characterised in that** the first and/or the second detection means (7, 7', 8, 8') can be fixed especially mechanically, preferably to the base (9), during the detection and/or the alignment and/or the contacting.

6. The device according to any one of the preceding claims, **characterised in that** the device can be calibrated by testing means for testing the alignment of the substrates (1, 2) brought into contact.

7. The device according to any one of the preceding claims, **characterised in that** the first and the second X-Y coordinate systems are Cartesian coordinate systems and/or have an identical scale and/or coincide.

8. The device according to any one of the preceding claims, **characterised in that** the first detection means (7, 7') comprises an, in particular single, first alignment key detector (1000, 1000') and/or the second detection means (8, 8') comprises an, in particular single, second alignment key detector (2000, 2000').

9. The device according to any one of the preceding claims, **characterised in that** first and second distance measuring devices (1002, 2002), in particular working contactless, and actuators (11, 21) for moving the substrates (1, 2) transversely with respect to the X-Y planes (5, 6) are provided for the parallel alignment of the first and second contact surfaces (1k, 2k).

10. A method for the alignment of a first contact surface (1k) of a first substrate (1) which can be mounted on a first platform (10) with a second contact surface (2k) of a second substrate (2) which can be mounted on a second platform (20) with the following steps:
- arrangement of the first contact surface (1k) in a first X-Y plane and the second contact surface (2k) in a second X-Y plane parallel to the first X-Y plane,
- detection of X-Y positions in a detection position of first alignment keys (3.1 to 3.n) arranged along the first contact surface (1k) in a first X-Y coordinate system independent of a movement of the first substrate (1) by detection means (7, 7'), and detection of X-Y positions of second alignment keys (4.1 to 4.n) corresponding to the first alignment keys (3.1 to 3.n) arranged along the second contact surface (2k) in a second X-Y coordinate system independent of a movement of the second substrate (2) by second detection means (8, 8'),
- detection in the detection position of the positions of the substrates by position detection means (30, 31, 31', 32, 33, 33', 34, 35, 35'),
- alignment of the first contact surface (1k) in a first alignment position determined on the basis of the first X-Y positions and alignment of the second contact surface (2k) in a second alignment position determined on the basis of the second X-Y positions and lying the opposite the first contact surface (1k),
**characterised in that** the first and second X-Y plane (5, 6) are identical during the detection of the first and second X-Y positions, wherein a divergence of the planes from one another of at most 20 µm is included.

## Revendications

1. Dispositif pour aligner une première surface de contact (1k) d'un premier substrat (1) pouvant être reçu sur une première plateforme (10), avec une seconde surface de contact (2k) d'un second substrat (2) pouvant être reçu sur une seconde plateforme (20), comprenant les caractéristiques suivantes :
- des premières positions X-Y de clés d'alignement (3.1 à 3.n) disposées le long de la première surface de contact (1k) peuvent être détectées dans une position de détection par des premiers moyens de détection (7, 7') dans un premier plan X-Y (5) dans un premier système de coordonnées X-Y indépendant d'un mouvement du premier substrat (1),
- des secondes positions X-Y de secondes clés d'alignement (4.1 à 4.n) correspondant aux premières clés d'alignement (3.1, 3.n) disposées le long de la seconde surface de contact (2k) peuvent être détectées dans la position de détection par des seconds moyens de détection (8, 8') dans un second plan X-Y (6) parallèle au premier plan X-Y (5) dans un second système de coordonnées X-Y indépendant d'un mouvement du second substrat (2),
- dans la position de détection, les positions des substrats (1, 2) peuvent être détectées par des moyens de détection de position (30, 31, 31', 32, 33, 33', 34, 35, 35'),
- la première surface de contact (1k) peut être alignée dans une première position d'alignement en se basant sur les premières positions X-Y et la seconde surface de contact (2k) peut être positionnée dans une seconde position d'alignement en se basant sur les secondes positions X-Y,
**caractérisé en ce que** le premier et le second plan X-Y (5, 6) sont identiques lors de la détection des première et seconde positions X-Y,
dans lequel un écart des plans l'un par rapport à l'autre de 20 µm maximum est détecté.

2. Dispositif selon la revendication 1, **caractérisé en ce que** des premières positions X-Y de plus de deux premières clés d'alignement (3.1 à 3.n) peuvent être détectées et alignées avec des secondes clés d'alignement (4.1 à 4.n) correspondantes.

3. Dispositif selon l'une des revendications précédentes, **caractérisé en ce que** le premier et le second plan X-Y (5, 6) sont en outre au moins quasi-identiques, de préférence identiques, avec un plan de contact de la première et de la seconde surface de contact (1k, 2k) lors de la mise en contact.

4. Dispositif selon l'une des revendications précédentes, **caractérisé en ce que** le premier et/ou le second système de coordonnées X-Y sont attribués à une base (9) du dispositif.

5. Dispositif selon l'une des revendications précédentes, **caractérisé en ce que** les premiers et/ou les seconds moyens de détection (7, 7', 8, 8') peuvent être fixés, de préférence à la base (9), pendant la détection et/ou l'alignement et/ou la mise en contact, en particulier mécaniquement.

6. Dispositif selon l'une des revendications précédentes, **caractérisé en ce que** le dispositif peut être calibré par des moyens de contrôle pour contrôler l'alignement des substrats (1, 2) mis en contact.

7. Dispositif selon l'une des revendications précédentes, **caractérisé en ce que** le premier et le second système de coordonnées X-Y sont des systèmes de coordonnées cartésiens et/ou présentent une mise à l'échelle identique et/ou coïncident.

8. Dispositif selon l'une des revendications précédentes, **caractérisé en ce que** les premiers moyens de détection (7, 7') présentent un, en particulier seul, premier détecteur de clé d'alignement (1000, 1000') et/ou les seconds moyens de détection (8, 8') présentent un, en particulier seul, second détecteur de clé d'alignement (2000, 2000').

9. Dispositif selon l'une des revendications précédentes, **caractérisé en ce que** pour l'alignement parallèle des première et seconde surfaces de contact (1k, 2k), des premier et second dispositifs de mesure de distance (1002, 2002), fonctionnant en particulier sans contact, ainsi que des déclencheurs (11, 21), sont prévus pour déplacer les substrats (1, 2) transversalement aux plans X-Y (5, 6).

10. Procédé d'alignement d'une première surface de contact (1k) d'un premier substrat (1) pouvant être reçu sur une première plateforme (10), avec une seconde surface de contact (2k) d'un second substrat (2) pouvant être reçu sur une seconde plateforme (20), comprenant les étapes suivantes :
- agencement de la première surface de contact (1k) dans un premier plan X-Y et de la seconde surface de contact (2k) dans un second plan X-Y parallèle au premier plan X-Y,
- détection de positions X-Y dans une position de détection de premières clés d'alignement (3.1 à 3.n) disposées le long de la première surface de contact (1k), dans un premier système de coordonnées X-Y indépendant d'un mouvement du premier substrat (1) par des premiers moyens de détection (7, 7'), et détection de positions X-Y de secondes clés d'alignement (4.1 à 4.n) correspondant aux premières clés d'alignement (3.1 à 3.n) disposées le long de la seconde surface de contact (2k) dans un second système de coordonnées X-Y indépendant d'un mouvement du second substrat (2) par des seconds moyens de détection (8, 8'),
- détection dans la position de détection, des positions des substrats par des moyens de détection de position (30, 31, 31', 32, 33, 33', 34, 35, 35'),
- alignement de la première surface de contact (1k) dans une première position d'alignement déterminée en se basant sur les premières positions X-Y et alignement de la seconde surface de contact (2k) dans une seconde position d'alignement déterminée en se basant sur les secondes positions X-Y, opposée à la première surface de contact (1k),
**caractérisé en ce que** le premier et le second plan X-Y (5, 6) sont identiques lors de la détection des première et seconde positions X-Y, dans lequel un écart des plans l'un par rapport à l'autre de 20 µm maximum est détecté.
